# EUROPEAN PATENT APPLICATION

(11) **EP 4 790 902 A1**
(43) Date of publication of application: **12.08.2026**
(21) Application number: 26156439.7
(22) Date of filing: 04.02.2026
(51) Int. Cl.: H03L 7/18, H03L 7/10, G11C 7/22

(54) **PHASE-LOCKED LOOP CIRCUIT, STORAGE DEVICE INCLUDING THE PHASE-LOCKED LOOP CIRCUIT, AND OPERATION METHOD OF THE STORAGE**

(30) Priority: 11.02.2025 KR 20250017516
(71) Applicant: Samsung Electronics Co., Ltd., Suwon-si, Gyeonggi-do 16677 (KR)
(72) Inventor: JUNG, Jinook, 16677 Suwon-si (KR); MAENG, Junyoung, 16677 Suwon-si (KR); KWAK, Myoungbo, 16677 Suwon-si (KR); PARK, Jaewoo, 16677 Suwon-si (KR); BAEK, Seungyeob, 16677 Suwon-si (KR)
(74) Representative: Marks & Clerk LLP

(57) **Abstract**

A storage device may include a non-volatile memory device and a storage controller including a phase-locked loop circuit, the phase-locked loop circuit may include a phase detector configured to output a phase-difference signal corresponding to a phase difference between the reference clock signal and the feedback clock signal; a voltage generator configured to generate an input voltage corresponding to the phase-difference signal and output the input voltage; an oscillator configured to generate an output clock signal having a frequency corresponding to the input voltage and output the output clock signal; a reset synchronization circuit configured to synchronize the reset signal based on the reference clock signal, and output a synchronous reset signal, and a frequency divider configured to reset based on the synchronous reset signal, generate the feedback clock signal by dividing a frequency of the output clock signal, and output the feedback clock signal.

## Description

### BACKGROUND

The present disclosure relates to a semiconductor device, and more particularly, to a phase-locked loop circuit, a storage device including the phase-locked loop circuit, and an operation method of the storage device.

Semiconductor memory is classified as volatile memory devices such as SRAM and DRAM, which lose stored data when the supply of power is cut off, and non-volatile memory devices such as flash memory devices, PRAM, MRAM, RRAM, and FRAM, which retain stored data even when the supply of power is cut off.

Phase-locked loops may receive reference clock signals, and may generate output clock signals having various frequencies higher than those of the reference clock signals by using the reference clock signals. Electronic devices are designed to operate based on clock signals having particular frequencies. Therefore, phase-locked loops are devices necessarily used in electronic devices.

It takes time for phase-locked loops to lock the frequencies of output clock signals to target frequencies. Until the frequencies of output clock signals of phase-locked loops are locked to target frequencies, electronic devices are not able to normally operate. Therefore, as the locking speeds of phase-locked loops increase, the operating speeds of electronic devices may increase.

### SUMMARY

Embodiments of the disclosure provide a phase-locked loop circuit that may have an improved (e.g., reduced) locking speed, a storage device including the phase-locked loop circuit, and an operation method of the storage device.

According to an aspect of the disclosure, a storage device may include: a non-volatile memory device, and a storage controller configured to control the non-volatile memory device and communicate with an external host device, the storage controller including a phase-locked loop circuit, the phase-locked loop circuit may include: a phase detector configured to receive a reference clock signal and a feedback clock signal, and output a phase-difference signal corresponding to a phase difference between the reference clock signal and the feedback clock signal; a voltage generator configured to receive the phase-difference signal, generate an input voltage corresponding to the phase-difference signal, and output the input voltage; an oscillator configured to receive the input voltage, generate an output clock signal that has a frequency corresponding to the input voltage, and output the output clock signal; a reset synchronization circuit configured to receive a reset signal and the reference clock signal, synchronize the reset signal based on the reference clock signal to generate a synchronous reset signal, and output the synchronous reset signal; and a frequency divider configured to receive the synchronous reset signal and the output clock signal, reset based on the synchronous reset signal, generate the feedback clock signal by dividing the frequency of the output clock signal, and output the feedback clock signal.

According to an aspect of the disclosure, a phase-locked loop circuit may include: a phase detector configured to receive a reference clock signal and a feedback clock signal, and output a phase-difference signal corresponding to a phase difference between the reference clock signal and the feedback clock signal; a reset synchronization circuit configured to receive a reset signal and the reference clock signal, synchronize the reset signal based on the reference clock signal to generate a synchronous reset signal, and output the synchronous reset signal; and a frequency divider configured to receive the synchronous reset signal and an output clock signal, reset based on the synchronous reset signal, generate the feedback clock signal by dividing a frequency of the output clock signal, and output the feedback clock signal to the phase detector. The phase-locked loop circuit may be configured to, based on being powered on, perform a locking operation for locking a phase of the output clock signal, by synchronizing the reset signal based on the reference clock signal.

According to an aspect of the disclosure, an operation method of (or method of operating) a storage device including a storage controller and a non-volatile memory device, the non-volatile memory device including a phase-locked loop circuit, may include: generating a synchronous reset signal that is synchronized to a reference clock signal, resetting a frequency divider in the phase-locked loop circuit based on the synchronous reset signal, generating an output clock signal, generating a feedback clock signal by dividing the frequency of the output clock signal, detecting a phase difference between the reference clock signal and the feedback clock signal, generating an input voltage corresponding to the phase difference, and generating the output clock signal that has the frequency corresponding to the input voltage.

According to an aspect of the disclosure, a phase-locked loop circuit may include: a phase detector configured to receive a reference clock signal and a feedback clock signal, and output a phase-difference signal corresponding to a phase difference between the reference clock signal and the feedback clock signal; a voltage generator configured to receive the phase-difference signal, generate an input voltage corresponding to the phase-difference signal, and output the input voltage; an oscillator configured to receive the input voltage, generate an output clock signal that has a frequency corresponding to the input voltage, and output the output clock signal; a reset synchronization circuit configured to receive a reset signal and the reference clock signal, synchronize the reset signal based on the reference clock signal to generate a synchronous reset signal, and output the synchronous reset signal; and a frequency divider configured to receive the synchronous reset signal and the output clock signal, reset based on the synchronous reset signal, generate the feedback clock signal by dividing the frequency of the output clock signal, and output the feedback clock signal.

At least some of the above and other features of the disclosure are set out in the claims.

### BRIEF DESCRIPTION OF THE DRAWINGS

The above and other aspects, features, and advantages of specific embodiments of the present disclosure will be more apparent from the following description with reference to the accompanying drawings, in which:
FIG. 1 is a block diagram illustrating a phase-locked loop circuit according to one or more embodiments;
FIG. 2 is a block diagram illustrating the phase-locked loop circuit of FIG. 1 according to one or more embodiments;
FIG. 3 is a timing diagram illustrating operation of the phase-locked loop circuit of FIG. 1 according to one or more embodiments;
FIG. 4 is a block diagram illustrating the phase-locked loop circuit of FIG. 1;
FIG. 5 is a diagram illustrating operation of a phase-locked loop circuit according to one or more embodiments;
FIG. 6 is a diagram illustrating operation of a phase-locked loop circuit according to one or more embodiments;
FIG. 7 is a block diagram illustrating a phase-locked loop circuit according to one or more embodiments;
FIG. 8 is a block diagram illustrating a phase-locked loop circuit according to one or more embodiments;
FIG. 9 is a flowchart illustrating an operation method of the phase-locked loop circuit of FIG. 1 according to one or more embodiments;
FIG. 10 is a block diagram illustrating a storage system according to one or more embodiments;
FIG. 11 is a block diagram illustrating a host interface circuit of FIG. 10 in more detail according to one or more embodiments;
FIG. 12 is a flowchart illustrating an example of an operation method of a storage controller of FIG. 10 according to one or more embodiments;
FIG. 13 is a flowchart illustrating an example of the operation method of the storage controller of FIG. 10 according to one or more embodiments; and
FIG. 14 is a diagram illustrating a system to which a phase-locked loop circuit according to one or more embodiments is applied.

### DETAILED DESCRIPTION

Hereinafter, example embodiments of the disclosure will be described clearly and in detail such that those of ordinary skill in the art are able to easily implement the disclosure.

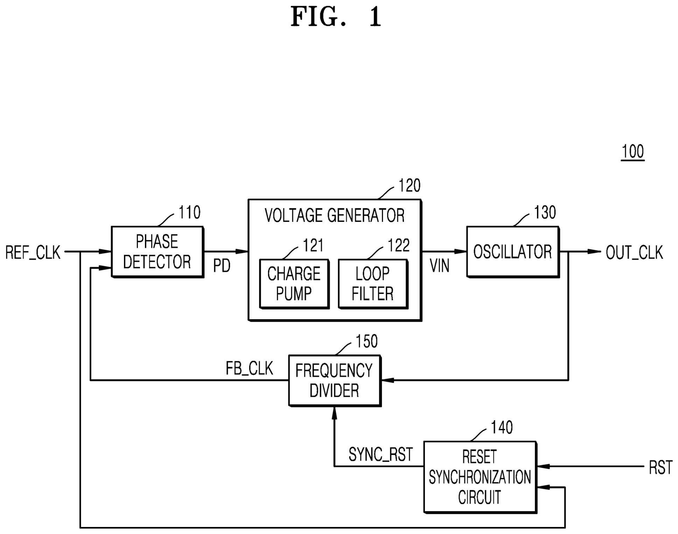

FIG. 1 is a block diagram illustrating a phase-locked loop circuit according to one or more embodiments.

In one or more embodiments, components of a phase-locked loop (PLL) circuit 100 may be fabricated by a semiconductor process. For example, the components of the PLL circuit 100 may be included in at least one chip (or die), and the at least one chip may be included in at least one semiconductor package.

In one or more embodiments, the PLL circuit 100 may receive a reference clock signal REF_CLK and a reset signal RST and may output an output clock signal OUT_CLK. The PLL circuit 100 may perform a locking operation for locking the frequency of the output clock signal OUT_CLK to a target frequency. The PLL circuit 100 may generate the output clock signal OUT_CLK, based on the reference clock signal REF_CLK. The output clock signal OUT_CLK may be synchronized to the reference clock signal REF_CLK. The output clock signal OUT_CLK may have a multiplied frequency from the frequency of the reference clock signal REF_CLK. The output clock signal OUT_CLK may be a clock signal having a locked phase or frequency.

In one or more embodiments, the reference clock signal REF_CLK may have a locked frequency like a crystal oscillator and may be referred to as an oscillating signal. In one or more embodiments, as shown in FIG. 1, the PLL circuit 100 may include a phase detector 110, a voltage generator 120, an oscillator 130, a reset synchronization circuit 140, and a frequency divider 150. However, the disclosure is not limited thereto. For example, the number of frequency dividers in the PLL circuit 100 may increase or decrease depending on implementations.

The phase detector 110 may receive the reference clock signal REF_CLK and a feedback clock signal FB_CLK and may output a phase-difference signal PD. The phase detector 110 may receive the feedback clock signal FB_CLK from the frequency divider 150. The phase detector 110 may generate the phase-difference signal PD. For example, the phase detector 110 may detect the phase difference between the reference clock signal REF_CLK and the feedback clock signal FB_CLK. The phase detector 110 may generate the phase-difference signal PD corresponding to the detected phase difference.

In one or more embodiments, the phase-difference signal PD may include an up signal, which is activated when the phase of the feedback clock signal FB_CLK lags behind the phase of the reference clock signal REF_CLK, and a down signal, which is activated when the phase of the feedback clock signal FB_CLK leads ahead of the phase of the reference clock signal REF_CLK. In one or more embodiments, the phase detector 110 may include logic gates and may also be referred to as a phase frequency detector.

The voltage generator 120 may receive the phase-difference signal PD from the phase detector 110 and may generate an input voltage VIN. The voltage generator 120 may generate the input voltage VIN corresponding to the phase-difference signal PD. For example, the voltage generator 120 may generate the input voltage VIN having a magnitude that corresponds to a phase difference indicated by the phase-difference signal PD. In one or more embodiments, the voltage generator 120 may include a charge pump 121 and a loop filter 122.

For example, the loop filter 122 may include a low-pass filter (LPF). The charge pump 121 may receive the phase-difference signal PD including an up signal and a down signal. The charge pump 121 may provide charges to the loop filter 122 in response to an activated up signal and may draw out charges from the loop filter 122 in response to an activated down signal. Therefore, the input voltage VIN generated by the loop filter 122 may have a magnitude corresponding to the phase difference. In one or more embodiments, the loop filter 122 may filter out a noise frequency. For example, the loop filter 122 may include at least one resistor or at least one capacitor.

The oscillator 130 may receive the input voltage VIN from the voltage generator 120. The oscillator 130 may receive a positive supply voltage from a voltage regulator and may generate the output clock signal OUT_CLK. The oscillator 130 may output the output clock signal OUT_CLK. The oscillator 130 may generate the output clock signal OUT_CLK having a frequency that corresponds to the input voltage VIN. For example, the oscillator 130 may generate the output clock signal OUT_CLK having a frequency that corresponds to the magnitude of the input voltage VIN, based on power supplied from a positive supply voltage.

For example, the oscillator 130 may include an inductor and a capacitor and may generate the output clock signal OUT_CLK having a resonance frequency of the inductor and the capacitor. Therefore, the oscillator 130 may generate the output clock signal OUT_CLK having low jitter. Herein, the oscillator 130 may be referred to as a voltage-controlled oscillator (VCO), and in particular, the oscillator 130 using a resonance frequency of an inductor and a capacitor may be referred to as an LC VCO.

The reset synchronization circuit 140 may receive the reference clock signal REF_CLK and the reset signal RST. The reset synchronization circuit 140 may generate a synchronous reset signal SYNC_RST. The reset synchronization circuit 140 may output the synchronous reset signal SYNC_RST to the frequency divider 150. The reset synchronization circuit 140 may synchronize the reset signal RST to the reference clock signal REF_CLK. The reset synchronization circuit 140 may synchronize the reset signal RST, based on the reference clock signal REF_CLK. The reset synchronization circuit 140 may generate the synchronous reset signal SYNC_RST that is synchronized to the reference clock signal REF_CLK.

In one or more embodiments, in response to the activation of the reset signal RST, the reset synchronization circuit 140 may be synchronized to the reference clock signal REF_CLK and thus activate the synchronous reset signal SYNC_RST. For example, in response to the activation of the synchronous reset signal SYNC_RST, the frequency divider 150 may be reset.

The frequency divider 150 may receive the output clock signal OUT_CLK and the synchronous reset signal SYNC_RST and may output the feedback clock signal FB_CLK. The frequency divider 150 may receive the output clock signal OUT_CLK from the oscillator 130. The frequency divider 150 may receive the synchronous reset signal SYNC_RST from the reset synchronization circuit 140. The frequency divider 150 may generate the feedback clock signal FB_CLK.

In one or more embodiments, the frequency divider 150 may generate the feedback clock signal FB_CLK by performing frequency division on the output clock signal OUT_CLK. For example, the frequency divider 150 may perform frequency division on the output clock signal OUT_CLK, based on 1/N that is a preset frequency division ratio. Therefore, the output clock signal OUT_CLK may have a frequency corresponding to N times the frequency of the reference clock signal REF_CLK. In one or more embodiments, the frequency divider 150 may be omitted, and the output clock signal OUT_CLK may be provided as the feedback clock signal FB_CLK to the phase detector 110 (that is, N=1).

In one or more embodiments, the frequency divider 150 may be reset in response to the synchronous reset signal SYNC_RST. The frequency divider 150 may generate the feedback clock signal FB_CLK synchronized to the reference clock signal REF_CLK, based on the synchronous reset signal SYNC_RST that is synchronized to the reference clock signal REF_CLK. The frequency divider 150 may generate the feedback clock signal FB_CLK having a similar phase to that of the reference clock signal REF_CLK, based on the synchronous reset signal SYNC_RST. The frequency divider 150 may generate the feedback clock signal FB_CLK having a phase difference of a threshold value or less from the reference clock signal REF_CLK, based on the synchronous reset signal SYNC_RST. The phase difference between the reference clock signal REF_CLK and the feedback clock signal FB_CLK may be less than that when the reset signal RST synchronized to the output clock signal OUT_CLK is received. Therefore, the lock time or operation time of the PLL circuit 100 may be reduced.

As described above, the PLL circuit 100 according to one or more embodiments may generate the synchronous reset signal SYNC_RST by synchronizing the reset signal RST to the reference clock signal REF_CLK. The PLL circuit 100 may reset the frequency divider 150, based on the synchronous reset signal SYNC_RST. Therefore, the frequency divider 150 may generate the feedback clock signal FB_CLK synchronized to the reference clock signal REF_CLK. Therefore, the PLL circuit 100 may reduce the initial phase difference between the reference clock signal REF_CLK and the feedback clock signal FB_CLK. The PLL circuit 100 may adjust the initial phase difference between the reference clock signal REF_CLK and the feedback clock signal FB_CLK to a preset value. The lock time of the PLL circuit 100 may be reduced.

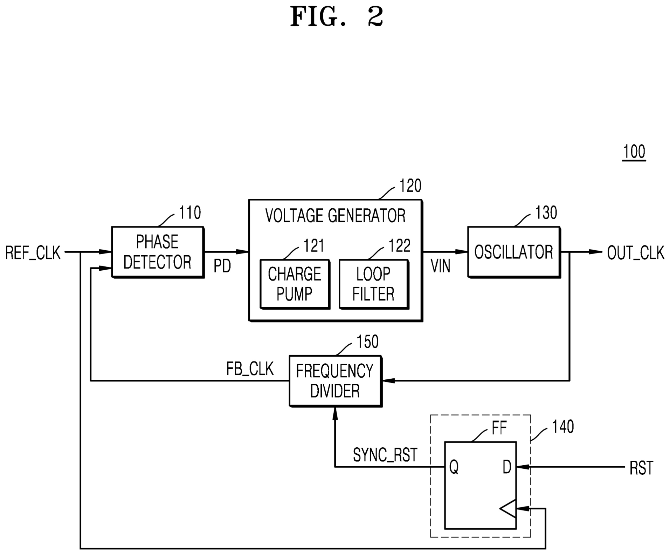

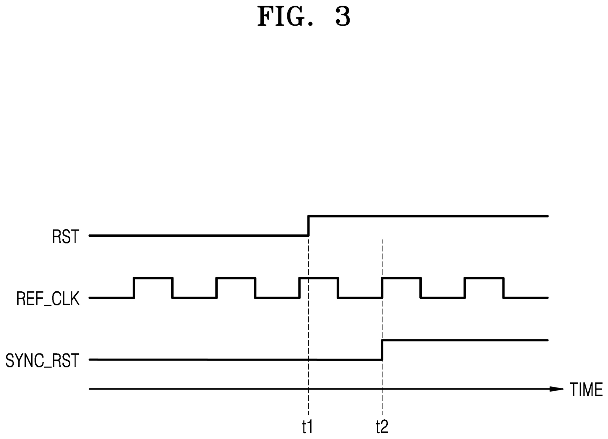

FIG. 2 is a block diagram illustrating the phase-locked loop circuit 100 of FIG. 1. FIG. 3 is a timing diagram illustrating an operation of the phase-locked loop circuit 100 of FIG. 1.

Referring to FIGS. 1, 2, and 3, the PLL circuit 100 may include a phase detector 110, a voltage generator 120, an oscillator 130, a reset synchronization circuit 140, and a frequency divider 150. For convenience of description, repeated descriptions of the components described above are omitted.

In one or more embodiments, the reset synchronization circuit 140 may include a flip-flop FF. The flip-flop FF may include a clock input terminal, an input terminal D, and an output terminal Q. The flip-flop FF may receive the reference clock signal REF_CLK via the clock input terminal, may receive the reset signal RST via the input terminal D, and may output the synchronous reset signal SYNC_RST via the output terminal Q.

The flip-flop FF may operate in response to the reference clock signal REF_CLK. The flip-flop FF may output a logic level (for example, a high level or a low level) of the reset signal RST as the synchronous reset signal SYNC_RST via the output terminal Q in response to a rising edge (or a falling edge) of the reference clock signal REF_CLK. Therefore, the synchronous reset signal SYNC_RST may be synchronized to the reference clock signal REF_CLK.

The reset signal RST may not be synchronized with the reference clock signal REF_CLK. A time point of the transition of the reset signal RST may be different from a time point of the transition of the reference clock signal REF_CLK. For example, the reset signal RST may be activated at a first time point t1 as shown in FIG. 3. The reset signal RST may transit from logic-low to logic-high at the first time point t1. The reference clock signal REF_CLK may transit from logic-low to logic-high at a second time point t2. The synchronous reset signal SYNC_RST may be activated at the second time point t2. The synchronous reset signal SYNC_RST may transit from logic-low to logic-high at the second time point t2. The synchronous reset signal SYNC_RST may be synchronized to the reference clock signal REF_CLK.

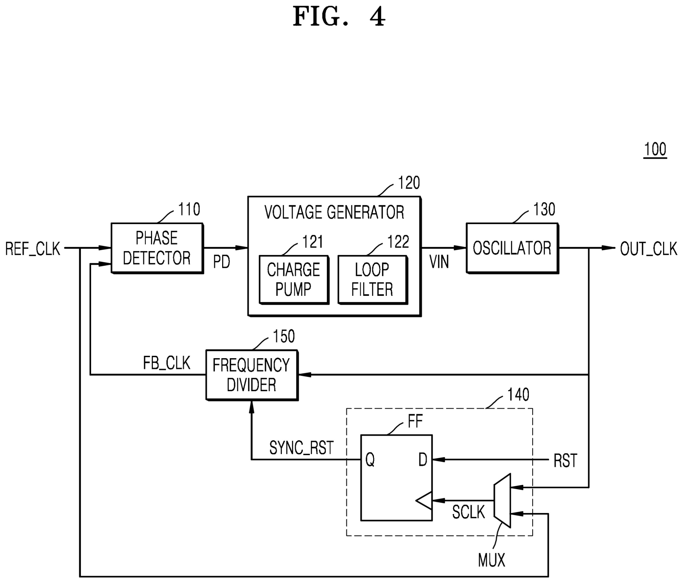

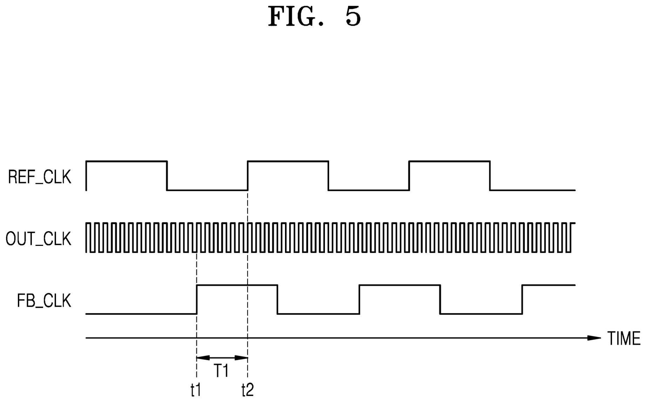

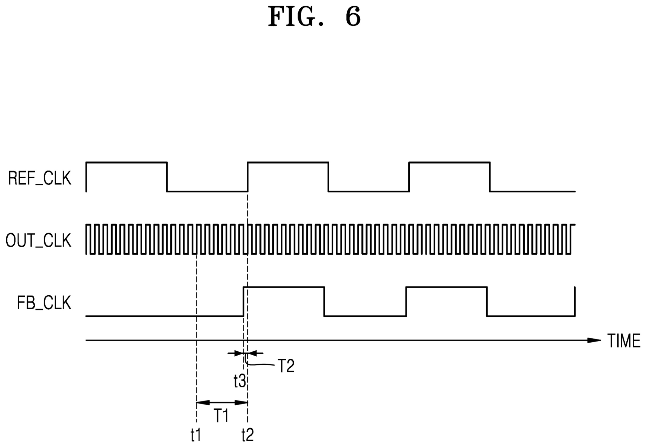

FIG. 4 is a block diagram illustrating the PLL circuit 100 of FIG. 1. FIGS. 5 and 6 are diagrams each illustrating an operation of a PLL circuit. FIG. 5 illustrates an example in which an output clock signal is output as a select clock signal, and FIG. 6 illustrates an example in which a reference clock signal is output as a select clock signal.

Referring to FIGS. 1, 4, 5, and 6, the PLL circuit 100 may include a phase detector 110, a voltage generator 120, an oscillator 130, a reset synchronization circuit 140, and a frequency divider 150. For convenience of description, repeated descriptions of the components described above are omitted.

In one or more embodiments, the reset synchronization circuit 140 may receive a select signal, the output clock signal OUT_CLK, the reference clock signal REF_CLK, and the reset signal RST. The reset synchronization circuit 140 may receive the output clock signal OUT_CLK from the oscillator 130. The reset synchronization circuit 140 may select a clock signal for synchronizing the reset signal RST. The reset synchronization circuit 140 may select one of the reference clock signal REF_CLK and the output clock signal OUT_CLK as a select clock signal SCLK, based on the select signal. The reset synchronization circuit 140 may generate the synchronous reset signal SYNC_RST that is synchronized to the select clock signal SCLK.

In one or more embodiments, the reset synchronization circuit 140 may include a flip-flop FF and a multiplexer MUX. In one or more embodiments, the multiplexer MUX may receive the select signal, the reference clock signal REF_CLK, and the output clock signal OUT_CLK. The multiplexer MUX may output the select clock signal SCLK. The multiplexer MUX may output one of the reference clock signal REF_CLK and the output clock signal OUT_CLK as the select clock signal SCLK. The multiplexer MUX may output one of the reference clock signal REF_CLK and the output clock signal OUT_CLK as the select clock signal SCLK in response to the select signal. For example, when the select signal is at logic-low, the multiplexer MUX may output the output clock signal OUT_CLK as the select clock signal SCLK. Alternatively, when the select signal is at logic-high, the multiplexer MUX may output the reference clock signal REF_CLK as the select clock signal SCLK.

The flip-flop FF may include a clock input terminal, an input terminal D, and an output terminal Q. The flip-flop FF may receive the select clock signal SCLK via the clock input terminal, may receive the reset signal RST via the input terminal D, and may output the synchronous reset signal SYNC_RST via the output terminal Q.

For example, when the select signal is at logic-low, the flip-flop FF may operate in response to the output clock signal OUT_CLK. The flip-flop FF may output the logic level (for example, the high level or the low level) of the reset signal RST as the synchronous reset signal SYNC_RST via the output terminal Q in response to a rising edge (or a falling edge) of the output clock signal OUT_CLK. The synchronous reset signal SYNC_RST may be synchronized to the output clock signal OUT_CLK.

In one or more embodiments, the frequency divider 150 may be reset in synchronization to the output clock signal OUT_CLK. The frequency divider 150 may generate the feedback clock signal FB_CLK that is synchronized to the output clock signal OUT_CLK. The feedback clock signal FB_CLK may not be synchronized to the reference clock signal REF_CLK. The phase difference between the feedback clock signal FB_CLK and the reference clock signal REF_CLK may be large. The phase difference between the feedback clock signal FB_CLK synchronized to the output clock signal OUT_CLK and the reference clock signal REF_CLK may be a first value. The lock time in the PLL circuit 100 may be increased.

Referring to FIG. 5, the phase difference between the reference clock signal REF_CLK and the feedback clock signal FB_CLK may be large. At the first time point t1, the output clock signal OUT_CLK may transit from logic-low to logic-high, and the feedback clock signal FB_CLK may transit from logic-low to logic-high. At the second time point t2, the reference clock signal REF_CLK may transit from logic-low to logic-high. The phase difference between the feedback clock signal FB_CLK and the reference clock signal REF_CLK may be large. The timing difference between the edge of the feedback clock signal FB_CLK and the edge of the reference clock signal REF_CLK may be a first time T1.

For example, when the select signal is at logic-high, the flip-flop FF may operate in response to the reference clock signal REF_CLK. The flip-flop FF may output the logic level (for example, the high level or the low level) of the reset signal RST as the synchronous reset signal SYNC_RST via the output terminal Q in response to the rising edge (or the falling edge) of the reference clock signal REF_CLK. The synchronous reset signal SYNC_RST may be synchronized to the reference clock signal REF_CLK.

In one or more embodiments, the frequency divider 150 may be reset in synchronization to the reference clock signal REF_CLK. The frequency divider 150 may generate the feedback clock signal FB_CLK that is synchronized to the reference clock signal REF_CLK. The feedback clock signal FB_CLK may be synchronized to the reference clock signal REF_CLK. When the synchronous reset signal SYNC_RST synchronized to the reference clock signal REF_CLK is provided to the frequency divider 150, the feedback clock signal FB_CLK may have a phase similar to the phase of the reference clock signal REF_CLK. The phase difference between the feedback clock signal FB_CLK and the reference clock signal REF_CLK may be small. The phase difference between the feedback clock signal FB_CLK synchronized to the reference clock signal REF_CLK and the reference clock signal REF_CLK may be a second value. The second value is less than the first value. The lock time in the PLL circuit 100 may be reduced.

Referring to FIG. 6, the phase difference between the reference clock signal REF_CLK and the feedback clock signal FB_CLK may be small. At the first time point t1, the output clock signal OUT_CLK may transit from logic-low to logic-high. At a third time point t3, the feedback clock signal FB_CLK may transit from logic-low to logic-high. At the second time point t2, the reference clock signal REF_CLK may transit from logic-low to logic-high. The phase difference between the feedback clock signal FB_CLK and the reference clock signal REF_CLK may be small. The timing difference between the edge of the feedback clock signal FB_CLK and the edge of the reference clock signal REF_CLK may be a second time T2. The second time T2 is less than the first time T1. That is, because the synchronous reset signal SYNC_RST is generated based on the reference clock signal REF_CLK, the phase difference between the reference clock signal REF_CLK and the feedback clock signal FB_CLK may be small. Therefore, the lock time or operation time in the PLL circuit 100 may be reduced.

As described above, the multiplexer MUX may output one of the reference clock signal REF_CLK and the output clock signal OUT _CLK as the select clock signal SCLK in response to the select signal. The phase difference between the feedback clock signal FB_CLK, which is generated by providing the synchronous reset signal SYNC_RST synchronized to the reference clock signal REF_CLK to the frequency divider 150, and the reference clock signal REF_CLK may be less than the phase difference between the feedback clock signal FB_CLK, which is generated by providing the synchronous reset signal SYNC_RST synchronized to the output clock signal OUT_CLK to the frequency divider 150, and the reference clock signal REF_CLK.

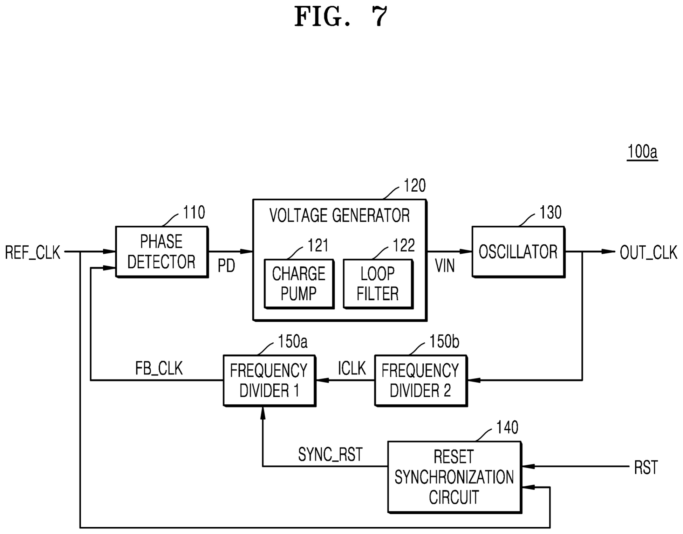

FIG. 7 is a block diagram illustrating a PLL circuit according to one or more embodiments.

Referring to FIGS. 1 and 7, a PLL circuit 100a may include a phase detector 110, a voltage generator 120, an oscillator 130, a reset synchronization circuit 140, a first frequency divider 150a, and a second frequency divider 150b. Because the PLL circuit 100a, the phase detector 110, the voltage generator 120, the oscillator 130, and the reset synchronization circuit 140 are respectively the same as or similar to the PLL circuit 100, the phase detector 110, the voltage generator 120, the oscillator 130, and the reset synchronization circuit 140 of FIG. 1, repeated descriptions thereof are omitted.

The second frequency divider 150b may receive the output clock signal OUT_CLK and may generate and output an intermediate clock signal ICLK. The second frequency divider 150b may generate the intermediate clock signal ICLK by frequency-dividing the output clock signal OUT_CLK. For example, the second frequency divider 150b may perform frequency division on the output clock signal OUT_CLK, based on a first frequency division ratio that is preset.

The first frequency divider 150a may receive the intermediate clock signal ICLK and the synchronous reset signal SYNC_RST and may generate and output the feedback clock signal FB_CLK. The first frequency divider 150a may generate the feedback clock signal FB_CLK by performing frequency division on the intermediate clock signal ICLK. For example, the first frequency divider 150a may perform frequency division on the intermediate clock signal ICLK, based on a second frequency division ratio that is preset. For example, the second frequency division ratio may be equal to or different from the first frequency division ratio.

In one or more embodiments, the first frequency divider 150a may be reset in response to the synchronous reset signal SYNC_RST. The first frequency divider 150a may generate the feedback clock signal FB_CLK synchronized to the reference clock signal REF_CLK, based on the synchronous reset signal SYNC_RST synchronized to the reference clock signal REF_CLK. The first frequency divider 150a may generate the feedback clock signal FB_CLK having a similar phase to the phase of the reference clock signal REF_CLK, based on the synchronous reset signal SYNC_RST.

In one or more embodiments, the second frequency divider 150b may be reset based on the reset signal synchronized to the output clock signal OUT_CLK. For example, the intermediate clock signal ICLK may be synchronized to the output clock signal OUT_CLK. Alternatively, the intermediate clock signal ICLK may have a similar phase to the phase of the output clock signal OUT_CLK.

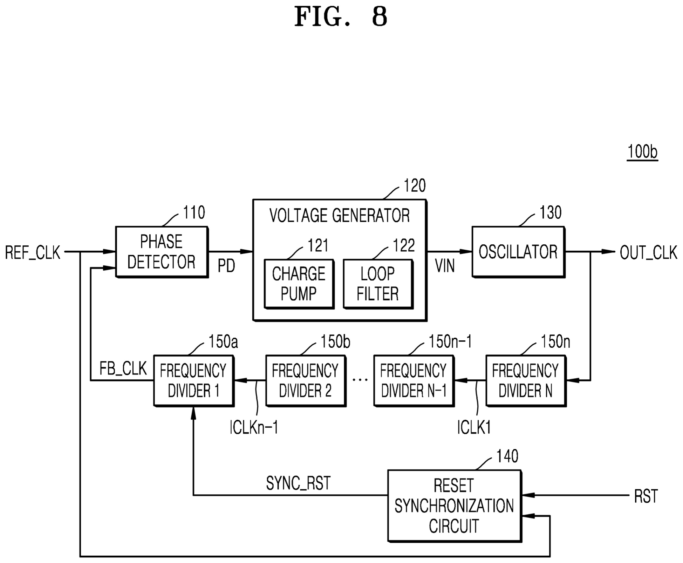

FIG. 8 is a block diagram illustrating a PLL circuit according to one or more embodiments.

Referring to FIGS. 1 and 8, a PLL circuit 100b may include a phase detector 110, a voltage generator 120, an oscillator 130, a reset synchronization circuit 140, and first to N-th frequency dividers 150a to 150n. The first to N-th frequency dividers 150a to 150n may be connected to each other in series. Because the PLL circuit 100b, the phase detector 110, the voltage generator 120, the oscillator 130, and the reset synchronization circuit 140 are respectively the same as or similar to the PLL circuit 100, the phase detector 110, the voltage generator 120, the oscillator 130, and the reset synchronization circuit 140 of FIG. 1, repeated descriptions thereof are omitted.

The N-th frequency divider 150n may receive the output clock signal OUT_CLK and may generate and output a first intermediate clock signal ICLK1. For example, the N-th frequency divider 150n may perform frequency division on the output clock signal OUT_CLK, based on a first frequency division ratio that is preset. The N-th frequency divider 150n may output the first intermediate clock signal ICLK1 to the N-1-th frequency divider 150n-1.

The N-1-th frequency divider 150n-1 may receive the first intermediate clock signal ICLK1 and may generate and output a second intermediate clock signal ICLK2. The N-1-th frequency divider 150n-1 may generate the second intermediate clock signal ICLK2 by performing frequency division on the first intermediate clock signal ICLK1. For example, the N-1-th frequency divider 150n-1 may perform frequency division on the first intermediate clock signal ICLK1, based on a second frequency division ratio that is preset. The second frequency division ratio may be equal to or different from the first frequency division ratio. The N-1-th frequency divider 150n-1 may output the second intermediate clock signal ICLK2 to the N-2-th frequency divider 150n-2.

The second frequency divider 150b may receive an N-2-th intermediate clock signal ICLKn-2 and may generate and output an N-1-th intermediate clock signal ICLKn-1. The second frequency divider 150b may generate the N-1-th intermediate clock signal ICLKn-1 by performing frequency division on the N-2-th intermediate clock signal ICLKn-2. For example, the second frequency divider 150b may perform frequency division on the N-2-th intermediate clock signal ICLKn-2, based on an N-1-th frequency division ratio that is preset. For example, the N-1-th frequency division ratio may be equal to or different from the first to N-2-th frequency division ratios. The second frequency divider 150b may output the N-1-th intermediate clock signal ICLKn-1 to the first frequency divider 150a.

The first frequency divider 150a may receive the N-1-th intermediate clock signal ICLKn-1 and the synchronous reset signal SYNC_RST and may generate and output the feedback clock signal FB_CLK. The first frequency divider 150a may generate the feedback clock signal FB_CLK by performing frequency division on the N-1-th intermediate clock signal ICLKn-1. For example, the first frequency divider 150a may perform frequency division on the N-1-th intermediate clock signal ICLKn-1, based on an N-th frequency division ratio that is preset. For example, the N-th frequency division ratio may be equal to or different from the first to N-1-th frequency division ratios. The first frequency divider 150a may output the feedback clock signal FB_CLK to the phase detector 110.

In one or more embodiments, the first frequency divider 150a may be reset in response to the synchronous reset signal SYNC_RST. The first frequency divider 150a may generate the feedback clock signal FB_CLK synchronized to the reference clock signal REF_CLK, based on the synchronous reset signal SYNC_RST synchronized to the reference clock signal REF_CLK. The first frequency divider 150a may generate the feedback clock signal FB_CLK having a similar phase to the phase of the reference clock signal REF_CLK.

In one or more embodiments, the first frequency divider 150a may be reset based on the synchronous reset signal SYNC_RST synchronized to the reference clock signal REF_CLK. The PLL circuit 100b may reset only the first frequency divider 150a, which is connected to the phase detector 110, with the synchronous reset signal SYNC_RST, thereby adjusting the phase of the feedback clock signal FB_CLK generated by the first frequency divider 150a so as to be similar to the phase of the reference clock signal REF_CLK.

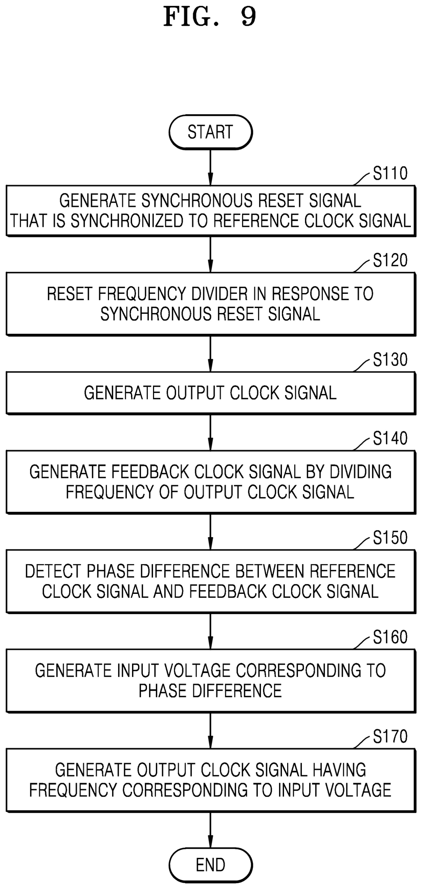

FIG. 9 is a flowchart illustrating an operation method of the PLL circuit 100 of FIG. 1.

Referring to FIGS. 1 and 9, the operation method of the PLL circuit 100 may include operations S110 to S170.

In operation S110, the PLL circuit 100 may generate the synchronous reset signal SYNC_RST synchronized to the reference clock signal REF_CLK. The reset synchronization circuit 140 may receive the reset signal RST and the reference clock signal REF_CLK and may output the synchronous reset signal SYNC_RST having a phase equal or similar to the phase of the reference clock signal REF_CLK.

In operation S120, the PLL circuit 100 may reset the frequency divider 150 in response to the synchronous reset signal SYNC_RST. The frequency divider 150 may receive the synchronous reset signal SYNC_RST and may be reset in response to the synchronous reset signal SYNC_RST that is activated.

In operation S130, the PLL circuit 100 may generate the output clock signal OUT_CLK. For example, the oscillator 130 may receive the input voltage VIN and may generate the output clock signal OUT_CLK having a frequency that corresponds to the input voltage VIN.

In operation S140, the PLL circuit 100 may generate the feedback clock signal FB_CLK by dividing the frequency of the output clock signal OUT_CLK. For example, the frequency divider 150 may generate the feedback clock signal FB_CLK synchronized to the reference clock signal REF_CLK. The frequency divider 150 may generate the feedback clock signal FB_CLK having a phase equal or similar to the phase of the reference clock signal REF_CLK.

In operation S150, the PLL circuit 100 may detect the phase difference between the reference clock signal REF_CLK and the feedback clock signal FB_CLK. The phase detector 110 may generate the phase-difference signal PD corresponding to the detected phase difference.

In operation S160, the PLL circuit 100 may generate the input voltage VIN corresponding to the phase difference. The voltage generator 120 may receive the phase-difference signal PD from the phase detector 110 and may generate the input voltage VIN. The voltage generator 120 may generate the input voltage VIN corresponding to the phase-difference signal PD.

In operation S170, the PLL circuit 100 may generate the output clock signal OUT_CLK having a frequency that corresponds to the input voltage VIN. For example, the oscillator 130 may generate the output clock signal OUT_CLK having a frequency that corresponds to the magnitude of the input voltage VIN, based on power provided from a positive supply voltage.

As described above, the PLL circuit 100 may synchronize the reset signal RST to the reference clock signal REF_CLK. The PLL circuit 100 may generate the feedback clock signal FB_CLK synchronized to the reference clock signal REF_CLK, based on the synchronous reset signal SYNC_RST. Therefore, the PLL circuit 100 may have improved (e.g., reduced) lock time. The operating speed of the PLL circuit 100 may improve (e.g., increase).

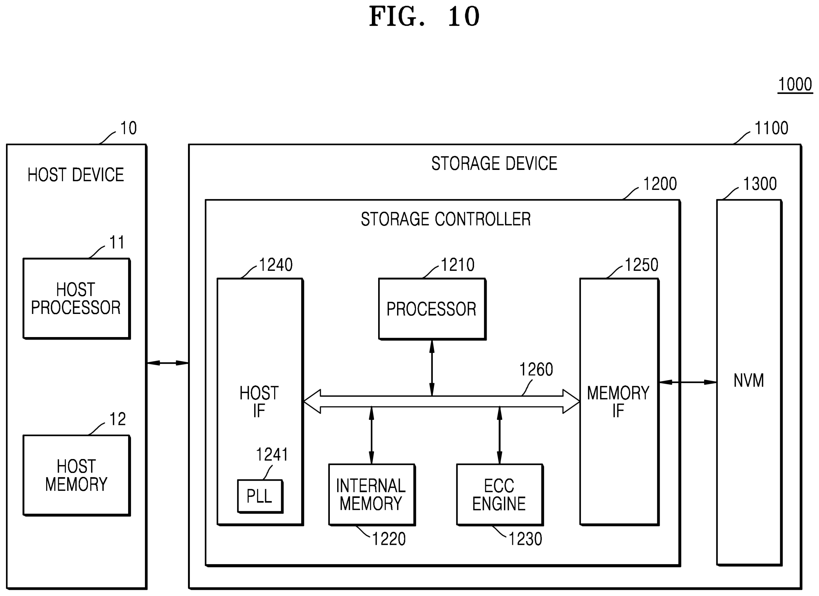

FIG. 10 is a block diagram illustrating a storage system according to one or more embodiments.

Referring to FIGS. 1 and 10, a storage system 1000 may include a host device 10 and a storage device 1100. The storage device 1100 may include a storage controller 1200 and a non-volatile memory device 1300.

In one or more embodiments, the storage controller 1200 and the non-volatile memory device 1300 may be implemented by separate semiconductor chips from each other. In addition, according to one or more embodiments, the components of the disclosure may be defined by other various terms. For example, the storage device 1100 may be referred to as a memory system or a data processing system, and the storage controller 1200 may be referred to as a memory controller or the like.

The storage device 1100 may include storage media for storing data according to requests from the host device 10. For example, the storage device 1100 may include one or more solid-state drives (SSDs). When the storage device 1100 includes an SSD, the non-volatile memory device 1300 may include a plurality of flash memory chips (for example, NAND chips) for non-volatilely storing data.

As another example, the storage device 1100 may include various types of memory. For example, the storage device 1100 may include non-volatile memory, such as magnetic random-access memory (MRAM), spin-transfer torque MRAM, conductive bridging RAM (CBRAM), ferroelectric RAM (FeRAM), phase-change RAM (PRAM), resistive RAM (RRAM), nanotube RAM, polymer RAM (PoRAM), nano-floating gate memory (NFGM), holographic memory, molecular electronics memory, or insulator resistance change memory.

The storage device 1100 may communicate with the host device 10 via various interfaces. For example, the storage device 1100 may communicate with the host device 10 via various interfaces, such as Universal Serial Bus (USB), Multimedia Card (MMC), Peripheral Component Interconnect express (PCIe), Advanced Technology Attachment (ATA), Serial ATA (SATA), Parallel ATA (PATA), Small Computer System Interface (SCSI), Serial Attached SCSI (SAS), Enhanced Small Disk Interface (ESDI), Integrated Drive Electronics (IDE), Compute Express Link (CXL), and Non-Volatile Memory Express (NVMe).

In one or more embodiments, the host device 10 may include a host processor 11 and a host memory 12. The host device 10 may be implemented by one of various electronic devices, such as a computer, a notebook computer, a smartphone, a smart pad, and a smart watch. The host processor 11 may control all operations of the host device 10 by executing instructions stored in the host memory 12. The host device 10 may encode or decode a packet satisfying standards defined in a certain interface. The host device 10 may generate, as a command, a packet instructing writing or reading. In addition, the host device 10 may receive a response provided from the storage device 1100.

The non-volatile memory device 1300 may include one or more NAND chips (or non-volatile memories), and each of the one or more NAND chips may include a memory cell array and a peripheral circuit. For example, the peripheral circuit of each of the NAND chips may perform write, read, and erase operations on data based on control by the storage controller 1200, and the memory cell array of each of the NAND chips may include one or more blocks.

The storage controller 1200 may control the non-volatile memory device 1300. The storage controller 1200 may communicate with the host device 10. The storage controller 1200 may include a processor 1210, an internal memory 1220, an error correction code (ECC) engine 1230, a host interface circuit 1240, a memory interface circuit 1250, and a bus 1260.

In one or more embodiments, various types of software executable by the processor 1210 may be loaded onto the internal memory 1220, and as an example, a flash translation layer (FTL) may be loaded onto the internal memory 1220. The internal memory 1220 may store data or output stored data according to control by the storage controller 1200. In one or more embodiments, the internal memory 1220 may include volatile memory. The internal memory 1220 may include RAM. For example, the internal memory 1220 may include static RAM or dynamic RAM. However, the disclosure is not limited thereto.

The (at least one) processor 1210 may control all operations of the storage controller 1200 by executing various pieces of software (or instructions) stored in the internal memory 1220. The processor 1210 may drive an operating system or firmware for driving the storage controller 1200. The processor 1210 may read interpreted requests stored in the internal memory 1220 and may generate commands and addresses for controlling the non-volatile memory device 1300. The processor 1210 may transfer the commands and the addresses, which are generated, to the memory interface circuit 1250.

The processor 1210 may store, in the internal memory 1220, various meta data for managing the storage device 1100. The processor 1210 may temporarily store, in the internal memory 1220, data that is received from the host device 10 and to be written to the non-volatile memory device 1300, or data that is read from the non-volatile memory device 1300 and to be transferred to the host device 10.

The processor 1210 may control the host interface circuit 1240 to transmit data stored in the internal memory 1220 to the host device 10 external to the storage device 1100. The processor 1210 may control the memory interface circuit 1250 to store, in the internal memory 1220, data received from the non-volatile memory device 1300. The processor 1210 may control the host interface circuit 1240 to store, in the internal memory 1220, data received from the external host device 10.

The memory interface circuit 1250 may provide an interface with one or more NAND chips that are included in the non-volatile memory device 1300. For example, the memory interface circuit 1250 may independently communicate with the NAND chips via a plurality of channels.

The host interface circuit 1240 may communicate with a host according to various interfaces such as PCIe and NVMe. The host interface circuit 1240 may store interpreted requests in the internal memory 1220. In addition, the host interface circuit 1240 may store, in the internal memory 1220, data received from the external host device 10. In addition, the host interface circuit 1240 may transmit data stored in the internal memory 1220 to the external host device 10. The host interface circuit 1240 may transmit various responses to the external host device 10. The host interface circuit 1240 may exchange signals with the external host device 10, based on a determined communication protocol.

The ECC engine 1230 may perform error detection and error correction on read data that is read from the non-volatile memory device 1300. More specifically, the ECC engine 1230 may generate parity bits for write data to be written to the non-volatile memory device 1300, and the parity bits generated as such may be stored, together with the write data, in the non-volatile memory device 1300. When data is read from the non-volatile memory device 1300, the ECC engine 1230 may correct errors in the read data by using the parity bits read from the non-volatile memory device 1300 together with the read data and may output the read data that is error-corrected.

The bus 1260 may provide communication channels between the components in the storage controller 1200. The host interface circuit 1240 may receive various requests from the external host device 10 and may interpret the received requests.

In one or more embodiments, the storage controller 1200 may receive the reference clock signal REF_CLK from the external host device 10. The host interface circuit 1240 may include a PLL circuit 1241. The PLL circuit 1241 may include the PLL circuit 100 described with reference to FIGS. 1 to 9. The PLL circuit 1241 may generate the output clock signal OUT_CLK by the method described with reference to FIGS. 1 to 9. The PLL circuit 1241 may perform a locking operation by the method described with reference to FIGS. 1 to 9.

In one or more embodiments, the PLL circuit 1241 may generate the output clock signal OUT_CLK, based on the reference clock signal REF_CLK. The storage controller 1200 may establish a link with the host device 10 by using the output clock signal OUT_CLK as an internal clock signal. According to a request transferred from the host device 10 via the link or to an internally determined schedule, the storage controller 1200 may access the non-volatile memory device 1300.

When returning from a low-power mode (for example, an L1 state) to an enabled mode (for example, an L0 state), it is difficult for a storage device to perform mode switching within the time required by standards due to the excessively long lock time in a PLL circuit. Therefore, there is a limit in that the PLL circuit is not able to be powered off when the storage device enters the low-power mode. The lock time in the PLL circuit is determined based on the initial phase difference between the reference clock signal REF_CLK and the feedback clock signal FB_CLK.

As described above, the storage device 1100 according to one or more embodiments may generate the synchronous reset signal SYNC_RST by synchronizing the reset signal RST to the reference clock signal REF_CLK. The storage device 1100 may reset a frequency divider in the PLL circuit 1241, based on the synchronous reset signal SYNC_RST. Therefore, the storage device 1100 may generate the feedback clock signal FB_CLK synchronized to the reference clock signal REF_CLK. Therefore, the storage device 1100 may reduce the initial phase difference between the reference clock signal REF_CLK and the feedback clock signal FB_CLK. The lock time in the PLL circuit 1241 may be reduced. The storage device 1100 may power off the PLL circuit 1241 in the low-power mode (for example, the L1 state). The storage device 1100 and the storage system 1000 both having reduced power consumption are provided. In other words, the PLL circuit 1241 is configured to power off based on entering the low-power mode.

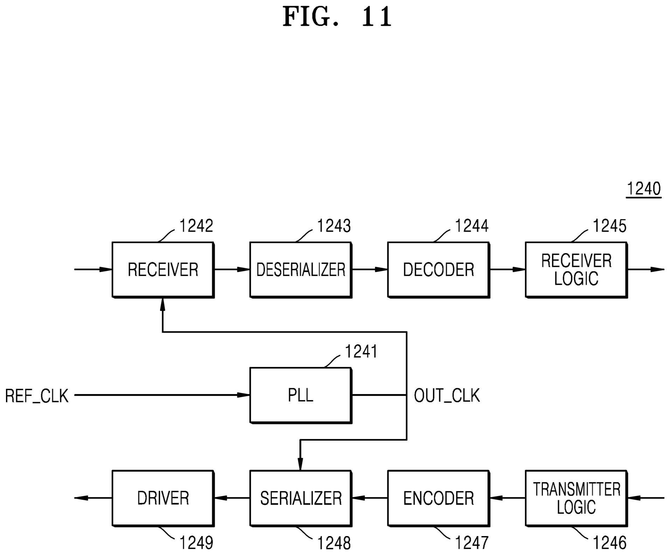

FIG. 11 is a block diagram illustrating the host interface circuit 1240 of FIG. 10 in more detail.

Referring to FIGS. 1, 10, and 11, the host interface circuit 1240 may include a PLL circuit 1241, a receiver 1242, a deserializer 1243, a decoder 1244, receiver logic 1245, transmitter logic 1246, an encoder 1247, a serializer 1248, and a driver 1249.

The PLL circuit 1241 may receive the reference clock signal REF_CLK and may output the output clock signal OUT_CLK synchronized to the reference clock signal REF_CLK. The receiver 1242 may receive a signal from the host device 10 via a link. The receiver 1242 may be synchronized to the output clock signal OUT_CLK and receive a signal. The signal received by the receiver 1242 may be a signal of a first type (for example, a serial type). The signal received by the receiver 1242 may be a portion of a packet or a portion of a symbol. The receiver 1242 may amplify the received signal and transfer the amplified signal to the deserializer 1243.

The deserializer 1243 may receive the signal from the receiver 1242. The deserializer 1243 may deserialize (or parallelize) the received signal. The deserializer 1243 may transfer, to the decoder 1244, the deserialized (or parallized) signal of a second type (for example, a parallel type).

The decoder 1244 may receive a signal of the second type from the deserializer 1243. The decoder 1244 may decode the signal of the second type. For example, the decoder 1244 may perform symbol decoding for extracting bits from a symbol. The decoder 1244 may extract 8-bit data from a 10-bit symbol. Alternatively, the decoder 1244 may extract 128-bit data from a 130-bit symbol. The decoder 1244 may transfer the decoded signal to the receiver logic 1245.

The receiver logic 1245 may receive the decoded signal from the decoder 1244. The receiver logic 1245 may determine the compliance of the decoded signal by performing pattern checking on the decoded signal. For example, the receiver logic 1245 may determine whether the decoded signal complies with a communication protocol (for example, PCIe) and, when the decoded signal complies with the communication protocol (for example, PCIe), may determine which generation of protocol the decoded signal complies with. When the pattern checking is successful, the receiver logic 1245 may transfer the decoded signal to the processor 1210 via the bus 1260.

The transmitter logic 1246 may receive a signal of the second type (for example the parallel type) from the processor 1210 via the bus 1260. The transmitter logic 1246 may combine a pattern with the signal of the second type. For example, the pattern may indicate which generation of communication protocol (for example, PCIe) the pattern corresponds to. The transmitter logic 1246 may transfer the combined signal to the encoder 1247.

The encoder 1247 may receive the combined signal from the transmitter logic 1246. The encoder 1247 may encode the combined signal. For example, the encoder 1247 may perform symbol encoding for generating a symbol from bits. The encoder 1247 may generate a 10-bit symbol from 8-bit data. Alternatively, the encoder 1247 may generate a 130-bit symbol from 128-bit data. The encoder 1247 may transfer the encoded signal to the serializer 1248.

The serializer 1248 may receive the encoded signal from the encoder 1247. The serializer 1248 may receive the output clock signal OUT_CLK from the PLL circuit 1241. The serializer 1248 may generate a signal of the first type (for example, the serial type) by serializing the encoded signal, based on the output clock signal OUT_CLK. The serializer 1248 may transfer the signal of the first type to the driver 1249. The driver 1249 may receive the signal of the first type from the serializer 1248. The driver 1249 may transfer the signal of the first type to the host device 10.

In one or more embodiments, the link between the storage controller 1200 and the host device 10 may have a plurality of states. For example, the plurality of states may include an initial state, a detection state, a polling state, a configuration state, an L0 state, an LOs state, an L1 state, an L2 state, a disabled state, a recovery state, a loopback state, and/or a hot reset state.

In one or more embodiments, the storage controller 1200 may enter the L0 state after the configuration state. The L0 state may be an enabled state or a normal state. In the L0 state, the storage controller 1200 may communicate with the host device 10 via the link. The storage controller 1200 may enter the L1 state from the L0 state. The L1 state may be a power-saving state or a low-power state for reducing power consumption. For example, the L0 state may correspond to an enabled mode or a high-speed mode, and the L1 state may correspond to a low-power mode.

In one or more embodiments, as the storage controller 1200 enters the L1 state from the L0 state, the PLL circuit 1241 may be powered off. As the storage controller 1200 enters the L0 state from the L1 state (or exits from the L1 state), the PLL circuit 1241 may be powered on. The PLL circuit 1241 may output the output clock signal OUT_CLK, based on the reference clock signal REF_CLK, in response to the power-on of the PLL circuit 1241. The PLL circuit 1241 may perform a locking operation for locking the phase of the output clock signal OUT_CLK.

In one or more embodiments, in the L0 state, the PLL circuit 1241 is in a power-on state and may generate and output the output clock signal OUT_CLK. For example, the PLL circuit 1241 may provide the output clock signal OUT_CLK to the receiver 1242, the serializer 1248, or the like. The storage controller 1200 may communicate with the host device 10 via the link. In the L1 state, the PLL circuit 1241 is in a power-off state and may not generate the output clock signal OUT_CLK. Therefore, power consumption may be reduced.

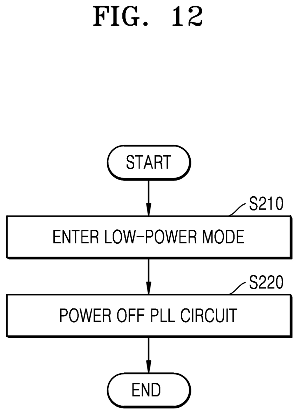

FIG. 12 is a flowchart illustrating an example of an operation method of (or method of operating) the storage controller 1200 of FIG. 10.

Referring to FIGS. 10 and 12, in operation S210, the storage controller 1200 may enter the low-power mode. In one or more embodiments, the storage controller 1200 may switch from the L0 state to the L1 state.

In operation S220, the storage controller 1200 may power off the PLL circuit 1241. The storage controller 1200 may power off the PLL circuit 1241 in response to the entry to the low-power mode. For example, the storage controller 1200 may power off the PLL circuit 1241, based on the entry to the L1 state. Therefore, the power consumption of the storage device 1100 may be reduced.

In one or more embodiments, in the low-power mode (or the L1 state), the PLL circuit 1241 may be powered off. The PLL circuit 1241 may not generate the output clock signal OUT_CLK. Alternatively, in the low-power mode (or the L1 state), the PLL circuit 1241 may be powered off. The PLL circuit 1241 may not output the output clock signal OUT_CLK.

As described above, in the low-power mode, the storage controller 1200 may power off the PLL circuit 1241, thereby reducing the power consumption of the storage controller 1200.

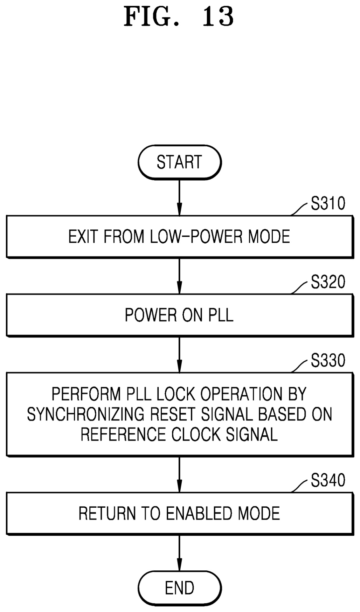

FIG. 13 is a flowchart illustrating an example of the operation method of (or method of operating) the storage controller 1200 of FIG. 10.

Referring to FIGS. 10 and 13, in operation S310, the storage controller 1200 may exit from the low-power mode. The storage controller 1200 may exit from the L1 state. For example, the storage controller 1200 may switch from the L1 state to the L0 state, when a data request is detected. In other words, the PLL circuit 1241 may power on, based on exiting from the low-power mode.

In operation S320, the storage controller 1200 may power on the PLL circuit 1241. In operation S330, in response to the power-on of the PLL circuit 1241, the storage controller 1200 may synchronize the reset signal RST, based on the reference clock signal REF_CLK, thereby performing a locking operation by the PLL circuit 1241. The PLL circuit 1241 may generate the synchronous reset signal SYNC_RST by synchronizing the reset signal RST to the reference clock signal REF_CLK. The PLL circuit 1241 may reset the frequency divider 150, based on the synchronous reset signal SYNC_RST. The PLL circuit 1241 may generate the feedback clock signal FB_CLK synchronized to the reference clock signal REF_CLK. The PLL circuit 1241 may lock the phase of the output clock signal OUT_CLK. The PLL circuit 1241 may reduce the phase difference between the feedback clock signal FB_CLK and the reference clock signal REF_CLK, thereby reducing the time for performing the locking operation.

In operation S340, the storage controller 1200 may return to the enabled mode. The storage controller 1200 may enter the L0 state. The storage controller 1200 may communicate with the host device 10, based on the output clock signal OUT_CLK.

As described above, the storage controller 1200 may generate the feedback clock signal FB_CLK having a phase equal or similar to the phase of the reference clock signal REF_CLK by using the synchronous reset signal SYNC_RST. Therefore, the lock time in the PLL circuit 1241 may be reduced. During the process of returning from the low-power mode to the enabled mode, as the time for the PLL circuit 1241 to perform the locking operation is reduced, a required timing condition may be satisfied.

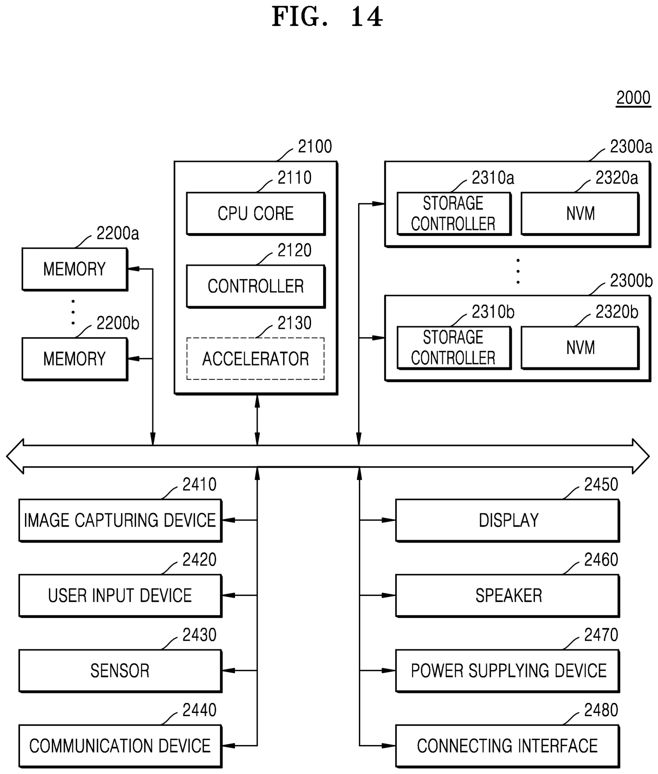

FIG. 14 is a diagram of a system to which a PLL circuit is applied, according to one or more embodiments. The system 2000 of FIG. 14 may basically be a mobile system, such as a portable communication terminal (e.g., a mobile phone), a smartphone, a tablet personal computer (PC), a wearable device, a healthcare device, or an Internet of things (IOT) device. However, the system 2000 of FIG. 14 is not necessarily limited to the mobile system and may be a PC, a laptop computer, a server, a media player, or an automotive device (e.g., a navigation device).

Referring to FIG. 14, the system 2000 may include a main processor 2100, memories (e.g., 2200a and 2200b), and storage devices (e.g., 2300a and 2300b). In addition, the system 2000 may include at least one of an image capturing device 2410, a user input device 2420, a sensor 2430, a communication device 2440, a display 2450, a speaker 2460, a power supplying device 2470, and a connecting interface 2480.

The main processor 2100 may control all operations of the system 2000, more specifically, operations of other components included in the system 2000. The main processor 2100 may be implemented as a general-purpose processor, a dedicated processor, or an application processor.

The main processor 2100 may include at least one CPU core 2110 and further include a controller 2120 configured to control the memories 2200a and 2200b and/or the storage devices 2300a and 2300b. In one or more embodiments, the main processor 2100 may further include an accelerator 2130, which is a dedicated circuit for a high-speed data operation, such as an artificial intelligence (AI) data operation. The accelerator 2130 may include a graphics processing unit (GPU), a neural processing unit (NPU) and/or a data processing unit (DPU) and be implemented as a chip that is physically separate from the other components of the main processor 2100.

The memories 2200a and 2200b may be used as main memory devices of the system 2000. Although each of the memories 2200a and 2200b may include a volatile memory, such as static RAM (SRAM) and/or dynamic RAM (DRAM), each of the memories 2200a and 2200b may include non-volatile memory, such as a flash memory, PRAM and/or RRAM. The memories 2200a and 2200b may be implemented in the same package as the main processor 2100.

The storage devices 2300a and 2300b may serve as non-volatile storage devices configured to store data regardless of whether power is supplied thereto, and have larger storage capacity than the memories 2200a and 2200b. The storage devices 2300a and 2300b may respectively include storage controllers 2310a and 2310b and Non-Volatile Memories (NVMs) 2320a and 2320b configured to store data via the control of the storage controllers 2310a and 2310b. Although the NVMs 2320a and 2320b may include flash memories having a two-dimensional (2D) structure or a three-dimensional (3D) V-NAND structure, the NVMs 2320a and 2320b may include other types of NVMs, such as PRAM and/or RRAM.

The storage devices 2300a and 2300b may be physically separated from the main processor 2100 and included in the system 2000 or implemented in the same package as the main processor 2100. In addition, the storage devices 2300a and 2300b may have types of solid-state devices (SSDs) or memory cards and be removably combined with other components of the system 2000 through an interface, such as the connecting interface 2480 that will be described below. The storage devices 2300a and 2300b may be devices to which a standard protocol, such as a universal flash storage (UFS), an embedded multi-media card (eMMC), or a non-volatile memory express (NVMe), is applied, without being limited thereto.

The image capturing device 2410 may capture still images or moving images. The image capturing device 2410 may include a camera, a camcorder, and/or a webcam.

The user input device 2420 may receive various types of data input by a user of the system 2000 and include a touch pad, a keypad, a keyboard, a mouse, and/or a microphone.

The sensor 2430 may detect various types of physical quantities, which may be obtained from the outside of the system 2000, and convert the detected physical quantities into electric signals. The sensor 2430 may include a temperature sensor, a pressure sensor, an illuminance sensor, a position sensor, an acceleration sensor, a biosensor, and/or a gyroscope sensor.

The communication device 2440 may transmit and receive signals between other devices outside the system 2000 according to various communication protocols. The communication device 2440 may include an antenna, a transceiver, and/or a modem.

The display 2450 and the speaker 2460 may serve as output devices configured to respectively output visual information and auditory information to the user of the system 2000.

The power supplying device 2470 may appropriately convert power supplied from a battery embedded in the system 2000 and/or an external power source, and supply the converted power to each of components of the system 2000.

The connecting interface 2480 may provide connection between the system 2000 and an external device, which is connected to the system 2000 and capable of transmitting and receiving data to and from the system 2000. The connecting interface 2480 may be implemented by using various interface schemes, such as ATA, SATA, external SATA (e-SATA), SCSI, SAS, PCI, PCIe, NVMe, IEEE 1394, a USB interface, a secure digital (SD) card interface, a multi-media card (MMC) interface, an eMMC interface, a UFS interface, an embedded UFS (eUFS) interface, and a compact flash (CF) card interface.

In one or more embodiments, each of the storage devices 2300a and 2300b may include a PLL circuit described with reference to FIGS. 1 to 13. Each of the storage devices 2300a and 2300b may synchronize the feedback clock signal FB_CLK to the reference clock signal REF_CLK, as described with reference to FIGS. 1 to 13. Therefore, each of the storage devices 2300a and 2300b may minimize the lock time in the PLL circuit and may have reduced power consumption.

According to an aspect of the disclosure, an operation method of (or method of operating) a storage device including a storage controller and a non-volatile memory device, the storage controller including a phase-locked loop circuit, may include: generating a synchronous reset signal that is synchronized to a reference clock signal; resetting a frequency divider in the phase-locked loop circuit based on the synchronous reset signal; generating an output clock signal; generating a feedback clock signal by dividing a frequency of the output clock signal; detecting a phase difference between the reference clock signal and the feedback clock signal; generating an input voltage corresponding to the phase difference; and generating the output clock signal that has the frequency corresponding to the input voltage.

The feedback clock signal may be synchronized to the reference clock signal.

The operation method may further include: receiving the reference clock signal from an external host device.

The operation method may further include: entering a low-power mode; and based on the entering the low-power mode, powering off the phase-locked loop circuit.

The operation method may further include: exiting from a low-power mode; powering on the phase-locked loop circuit; based on the powering on of the phase-locked loop circuit, performing a locking operation for locking a phase of the output clock signal, by synchronizing the synchronous reset signal based on the reference clock signal; and returning to an enabled mode.

The low-power mode may correspond to an L1 state of a PCI express (PCIe) standard, and the enabled mode may correspond to an L0 state of the PCIe standard.

While certain example embodiments of the disclosure have been particularly shown and described, it will be understood that various changes in form and details may be made therein without departing from the scope of the following claims.

## Claims

1. A storage device (1100) comprising:
a non-volatile memory device (1300); and
a storage controller (1200) configured to control the non-volatile memory device (1300) and communicate with an external host device (10), the storage controller (1200) comprising a phase-locked loop circuit (100),
wherein the phase-locked loop circuit (100) comprises:
a phase detector (110) configured to receive a reference clock signal (REF_CLK) and a feedback clock signal (FB_CLK), and output a phase-difference signal (PD) corresponding to a phase difference between the reference clock signal (REF_CLK) and the feedback clock signal (FE_CLK);
a voltage generator (120) configured to receive the phase-difference signal (PD), generate an input voltage (VIN) corresponding to the phase-difference signal (PD), and output the input voltage (VIN);
an oscillator (130) configured to receive the input voltage (VIN), generate an output clock signal (OUT_CLK) that has a frequency corresponding to the input voltage (VIN), and output the output clock signal (OUT_CLK);
a reset synchronization circuit (140) configured to receive a reset signal (RST) and the reference clock signal (REF_CLK), synchronize the reset signal (RST) based on the reference clock signal (REF_CLK) to generate a synchronous reset signal (SYNC _RST), and output the synchronous reset signal (SYNC_RST); and
a frequency divider (150) configured to receive the synchronous reset signal (SYNC_RST) and the output clock signal (OUT_CLK), reset based on the synchronous reset signal (SYNC_RST), generate the feedback clock signal (FB_CLK) by dividing the frequency of the output clock signal (OUT_CLK), and output the feedback clock signal (FB_CLK).

2. The storage device (1100) of claim 1, wherein the feedback clock signal (FB_CLK) is synchronized to the reference clock signal (REF_CLK).

3. The storage device (1100) of claim 1 or 2, wherein the voltage generator (120) comprises:
a loop filter (122) configured to filter out a noise frequency; and
a charge pump (121) configured to provide charges to or draw out charges from the loop filter (122), based on the phase-difference signal (PD).

4. The storage device (1100) of any preceding claim, wherein the reset synchronization circuit (140) comprises a flip-flop configured to receive the reference clock signal (REF_CLK) via a clock input terminal, receive the reset signal (RST) via an input terminal (D), and output the synchronous reset signal (SYNC_RST) via an output terminal (Q).

5. The storage device (1100) of any of claims 1 to 3, wherein the reset synchronization circuit (140) comprises:
a multiplexer configured to receive a select signal, the reference clock signal (REF_CLK), and the output clock signal (OUT_CLK) and output one of the reference clock signal (REF_CLK) and the output clock signal (OUT_CLK) as a select clock signal (SCLK) based on the select signal, and
a flip-flop configured to receive the select clock signal (SCLK) via a clock input terminal, receive the reset signal (RST) via an input terminal (D), and output the synchronous reset signal (SYNC_RST) via an output terminal (Q).

6. The storage device (1100) of any preceding claim, wherein the storage controller (1200) is further configured to receive the reference clock signal (REF_CLK) from the external host device (10).

7. The storage device (1100) of any preceding claim, wherein the storage controller (1200) is further configured to, based on entering a low-power mode, power off the phase-locked loop circuit (100).

8. The storage device (1100) of any of claims 1 to 6, wherein the storage controller (1200) is further configured to, based on exiting from a low-power mode, power on the phase-locked loop circuit (100).

9. The storage device (1100) of claim 8, wherein the phase-locked loop circuit (100) is configured to, based on being powered on, perform a locking operation for locking a phase of the output clock signal (OUT_CLK), by synchronizing the reset signal (RST) based on the reference clock signal (REF_CLK).

10. The storage device (1100) of claim 8 or 9, wherein the low-power mode corresponds to an L1 state of a PCI express, PCIe, standard.

11. An operation method of a storage device (1100) comprising a storage controller (1200) and a non-volatile memory device (1300), wherein the storage controller (1200) comprises a phase-locked loop circuit (100), the operation method comprising:
generating (S110) a synchronous reset signal (SYNC_RST) that is synchronized to a reference clock signal (REF_CLK);
resetting (S120) a frequency divider (150) in the phase-locked loop circuit (100) based on the synchronous reset signal (SYNC_RST);
generating (S130) an output clock signal (OUT_CLK);
generating (S140) a feedback clock signal (FB_CLK) by dividing a frequency of the output clock signal (OUT_CLK);
detecting (S150) a phase difference between the reference clock signal (REF_CLK) and the feedback clock signal (FB_CLK);
generating (S160) an input voltage (VIN) corresponding to the phase difference; and
generating (S170) the output clock signal (OUT_CLK) that has a frequency corresponding to the input voltage (VIN).

12. The operation method of claim 11, wherein the feedback clock signal (FB_CLK) is synchronized to the reference clock signal (REF_CLK).

13. The operation method of claim 11 or 12, further comprising receiving the reference clock signal (REF_CLK) from an external host device (10).

14. The operation method of any of claims 11 to 13, further comprising:
entering (S210) a low-power mode; and
based on the entering the low-power mode, powering (S220) off the phase-locked loop circuit (100).

15. The operation method of any of claims 11 to 13, further comprising:
exiting (S310) from a low-power mode;
powering (S320) on the phase-locked loop circuit (100);
based on the powering on of the phase-locked loop circuit (100), performing (S330) a locking operation for locking a phase of the output clock signal (OUT _CLK), by synchronizing a reset signal (RST) based on the reference clock signal (REF_CLK); and
returning (S340) to an enabled mode.
